# DEMANDE DE BREVET EUROPEEN

(11) **EP 4 191 879 A1**
(43) Date de publication de la demande: **07.06.2023**
(21) Numéro de dépôt: 22211346.6
(22) Date de dépôt: 05.12.2022
(51) Int. Cl.: H03H 3/08, H03H 9/02, H03H 3/02, H10N 30/081

(54) **PROCÉDÉ DE TRANSFERT D'UNE COUCHE**

(30) Priorité: 06.12.2021 FR 2113024
(71) Demandeur: Commissariat à l'énergie atomique et aux énergies alternatives, 75015 Paris (FR)
(72) Inventeur: DUPONT, Florian, 38054 GRENOBLE Cedex 09 (FR); RODRIGUEZ, Guillaume, 38054 GRENOBLE Cedex 09 (FR)
(74) Mandataire: Hautier IP

(57) **Abrégé**

L'invention porte sur un procédé de report d'une couche d'intérêt (12) depuis un substrat donneur (10) vers un substrat receveur (20), comprenant les étapes suivantes :
- Fournir le substrat donneur (10) en un matériau transparent à une longueur d'onde λ,
- Former au moins une couche tampon sacrificielle (11) en un matériau sacrificiel absorbant à la longueur d'onde λ, sur le substrat donneur,
- Former la couche d'intérêt (12) sur l'au moins une couche tampon sacrificielle (11),
- Coller la couche d'intérêt (12) sur le substrat receveur (20),
- Illuminer par laser à la longueur d'onde A l'au moins une couche tampon sacrificielle (11) au travers du substrat donneur (10), de sorte à éliminer ladite au moins une couche tampon sacrificielle (11) pour désolidariser la couche d'intérêt (12) du substrat donneur (10).

## Description

### DOMAINE TECHNIQUE

La présente invention concerne, en général, un procédé de transfert d'une couche. Ce procédé permet avantageusement de transférer une couche de bonne qualité cristalline, depuis un substrat donneur vers un substrat receveur. Une application particulièrement intéressante de la mise en œuvre de ce procédé est la fabrication de dispositifs électro-acoustiques, par exemple des dispositifs à onde acoustique de surface ou à onde acoustique de volume, sur un substrat receveur à base de silicium.

### ETAT DE LA TECHNIQUE

Les résonateurs basés sur une structure de type « onde acoustique de surface » dite SAW (acronyme de « Surface Acoustic Wave ») ou de type « onde acoustique de volume» dite BAW (acronyme de « Bulk Acoustic Wave ») sont couramment utilisés pour réaliser des filtres radiofréquences (RF). Le cœur de ces résonateurs est composé d'un matériau piézoélectrique qui influence les propriétés finales du filtre.

Le niobate de lithium (LiNbO3) est utilisé depuis plusieurs années en tant que matériau piézoélectrique. Ses propriétés intrinsèques, comme son coefficient de couplage piézoélectrique, pourrait permettre aux filtres de résonner à haute fréquence, par exemple à des fréquences supérieures à 3,5 GHz, et/ou avec une large bande passante, par exemple jusqu'à 600MHz. Pour obtenir un coefficient de couplage élevé, typiquement jusqu'à 50%, la couche piézoélectrique à base de LiNbO3 doit notamment présenter une haute qualité cristalline et une stœchiométrie contrôlée.

Une haute qualité cristalline et une stœchiométrie contrôlée sont généralement obtenues en faisant croître des substrats massifs de LiNbO3. De tels substrats ne conviennent cependant pas à la plupart des applications dans les domaines des dispositifs électro-acoustiques et des dispositifs optiques, qui requièrent généralement une couche mince de LiNbO3.

Le document « A. Reinhardt et al., Acoustic filters based on thin single crystal LiNbO3 films: Status and prospects Proc. - IEEE Ultrason. Symp. 2014, 773 » divulgue une solution basée sur un procédé de report connu sous la dénomination Smart-Cut^{™} permettant de fabriquer un filtre BAW comprenant une couche piézoélectrique à base de LiNbO3 sur substrat silicium. Une couche mince de LiNbO3 est prélevée d'un substrat donneur, typiquement à partir d'un substrat de LiNbO3 monocristallin, puis reportée vers un substrat receveur, typiquement un substrat de silicium. Cette solution met en œuvre de nombreuses étapes techniques et présente un coût significatif.

Par ailleurs, cette méthode de report par Smart- Cut^{™} ne permet pas de reporter des couches minces de faible épaisseur, par exemple de quelques dizaines de nanomètres, ni de reporter des couches minces de forte épaisseur, typiquement de l'ordre de 1µm ou plus.

Par ailleurs, la nécessité d'un recuit de guérison suite à l'implantation ionique soumet le substrat à de hautes températures. Cela empêche l'utilisation de couches fonctionnalisées sous le substrat.

Il existe donc un besoin consistant à reporter une couche à base de niobate de lithium ou d'un matériau présentant des propriétés similaires, tel que le tantalate de lithium par exemple, sur un substrat à base de silicium, en limitant les coûts, et pour une large gamme d'épaisseurs de couche.

Un objectif de la présente invention est de répondre au moins en partie à ce besoin.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de report d'une couche d'intérêt depuis un substrat donneur vers un substrat receveur, ladite couche d'intérêt étant à base de niobate de lithium (LiNbO3), ou de tantalate de lithium (LiTaO3), ou d'un alliage Li(Ta,Nb)O3, ou d'une pérovskite oxyde ABO3, O étant l'oxygène, A et B étant deux éléments chimiques distincts pris parmi le calcium (Ca), le sodium (Na), le potassium (K), le baryum (Ba), le lithium (Li), le plomb (Pb), le zirconium (Zr), le titane (Ti), le niobium (Nb), le tantale (Ta). Le procédé comprend les étapes suivantes :
- Fournir le substrat donneur en un matériau transparent à une longueur d'onde λ,
- Former au moins une couche tampon sacrificielle en un matériau sacrificiel absorbant à la longueur d'onde λ, par épitaxie sur le substrat donneur,
- Former la couche d'intérêt par épitaxie sur l'au moins une couche tampon sacrificielle,
- Coller la couche d'intérêt sur le substrat receveur,
- Illuminer par laser à la longueur d'onde λ l'au moins une couche tampon sacrificielle au travers du substrat donneur, de sorte à éliminer au moins en partie ladite au moins une couche tampon sacrificielle pour désolidariser ou contribuer à désolidariser la couche d'intérêt du substrat donneur.

Ainsi, le procédé permet avantageusement de décoller une couche d'intérêt crue par épitaxie, sans implantation, en utilisant une couche tampon sacrificielle au moins partiellement éliminable par laser. Ce procédé peut donc être qualifié de procédé de « lift off » laser (« lift off » étant le terme généralement utilisé et signifiant décollement, en français). L'élimination au moins partielle de la couche tampon sacrificielle peut se faire par évaporation et/ou par dissociation par exemple. Le flux et/ou les paramètres du laser (puissance, durée, fréquence...) sont typiquement choisis afin d'obtenir une dissociation effective de la couche tampon sacrificielle.

Selon le procédé, la couche tampon sacrificielle est choisie de sorte à absorber une majeure partie du flux lumineux de longueur d'onde λ. Le substrat donneur, et de préférence la couche d'intérêt, sont choisis de façon à être transparents à la longueur d'onde λ. Ainsi, seule la couche tampon sacrificielle est affectée par le flux lumineux lors de l'illumination laser. La couche tampon sacrificielle est dissociée sélectivement par rapport au substrat et la couche d'intérêt. La couche d'intérêt n'est avantageusement pas affectée par le flux lumineux. Cela évite d'induire des défauts structuraux dans la couche d'intérêt.

Selon le procédé, la couche tampon sacrificielle et la couche d'intérêt sont épitaxiées sur le substrat donneur. Une relation d'épitaxie existe donc entre la couche d'intérêt et le substrat via la couche tampon sacrificielle. Les orientations cristallines du substrat donneur, de la couche tampon sacrificielle et de la couche d'intérêt sont de préférence identiques. La croissance de la couche tampon sacrificielle et la croissance de la couche d'intérêt se font de préférence de façon à garder une cohérence structurelle avec le substrat donneur. Ainsi, le paramètre de maille de la couche tampon sacrificielle est environ égal à celui du substrat donneur. La structure cristalline de la couche tampon sacrificielle n'est pas relaxée. Le paramètre de maille de la couche d'intérêt est environ égal à celui de la couche tampon sacrificielle. Cela évite l'apparition de défauts structuraux par relaxation plastique des contraintes mécaniques dans la couche tampon sacrificielle et/ou dans la couche d'intérêt. Selon un exemple, la couche d'intérêt et le substrat donneur sont à base du même matériau.

Les différentes couches épitaxiées conservent typiquement une continuité cristalline entre les unes et les autres. Ainsi, le substrat donneur, la couche tampon sacrificielle, la couche d'intérêt présentent une continuité cristalline dans le plan, de manière similaire à un monocristal. Cela permet d'obtenir une qualité supérieure. Les différentes épitaxies impliquent typiquement certaines contraintes sur le choix des matériaux, notamment en termes de structure cristalline, et de procédé permettant l'épitaxie des différentes couches de l'empilement.

La couche tampon sacrificielle présente donc au moins une première fonction consistant à assurer la croissance par épitaxie de la couche d'intérêt, et au moins une deuxième fonction consistant à permettre le lift off laser.

Avantageusement, le procédé permet d'obtenir une qualité cristalline de la couche d'intérêt élevée, comparable à la qualité cristalline d'une couche homoépitaxiée. Par ailleurs, toutes les épaisseurs de couche d'intérêt sont réalisables, notamment des faibles épaisseurs de quelques nanomètres ou dizaines de nanomètres, du fait de la formation de cette couche d'intérêt par croissance.

Avantageusement, après lift off laser, le substrat donneur n'est pas endommagé. Contrairement à une implantation ionique, l'illumination par laser n'endommage pas le substrat donneur. Il peut être réutilisé de façon à effectuer une nouvelle croissance de couche tampon sacrificielle et de couche d'intérêt.

Ainsi, par rapport au procédé de report connu sous la dénomination Smart-Cut^{™}, le procédé de report selon la présente invention permet de reporter la couche d'intérêt en limitant les coûts, sans implantation ni recuit de guérison. Il permet également de viser une plus large gamme d'épaisseur de couche d'intérêt.

Selon un exemple préféré, la couche d'intérêt est à base de l'un parmi le niobate de lithium LiNbO3, le tantalate de lithium LiTaO3, ou un alliage, par exemple Li(Nb,Ta)O3. La couche tampon sacrificielle peut être à base de nitrure d'aluminium AIN ou AlInN. On choisira dans ce cas une illumination laser à une longueur d'onde λ du domaine ultraviolet UV. Alternativement, la couche tampon sacrificielle peut être à base de nitrure de titane TiN. On choisira dans ce cas de préférence une illumination laser à une longueur d'onde λ du domaine infrarouge IR. Le substrat est de préférence à base du même

Selon un préjugé technique, une couche d'intérêt à base de LiNbO3 ou de LiTaO3, dite couche LN/LT, doit nécessairement être épitaxiée sur une couche tampon à base d'oxyde, afin d'éviter une perte de stœchiométrie de la couche LN/LT par diffusion d'oxygène.

Au contraire, dans le cadre du développement de la présente invention, il a été observé de manière parfaitement inattendue qu'une couche tampon à base d'un nitrure permet l'épitaxie de la couche LN/LT dans de bonnes conditions. De façon surprenante, il a été également observé qu'une telle couche tampon permet de bloquer à la fois la diffusion d'oxygène et la diffusion du lithium vers le substrat donneur. Il en résulte que la couche LN/LT épitaxiée sur une telle couche tampon conserve la stœchiométrie requise.

Par ailleurs, une telle couche tampon à base de nitrure absorbe généralement dans l'UV et/ou dans l'IR, tandis que la couche LN/LT et le substrat donneur sont transparents dans ces domaines de longueur d'onde. Une telle couche tampon « sacrificielle » est donc avantageusement au moins en partie dissociée par illumination UV ou IR.

La présente invention propose ainsi une solution peu coûteuse permettant de transférer une couche d'intérêt de haute qualité cristalline sur un substrat receveur adapté aux applications visées, par exemple un substrat receveur à base de silicium.

### BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :
Les figures 1A à 1I illustrent en coupe transverse un procédé de transfert d'une couche d'intérêt selon un mode de réalisation la présente invention.
La figure 2 illustre en coupe transverse une couche tampon sacrificielle comprenant une pluralité de sous-couches alternées, selon un mode de réalisation la présente invention.
Les figures 3A à 3F illustrent en coupe transverse un procédé de transfert d'une couche d'intérêt selon un autre mode de réalisation la présente invention.
Les figures 4A à 4E illustrent en coupe transverse un procédé de transfert d'une couche d'intérêt selon un autre mode de réalisation la présente invention.
La figure 5 illustre une courbe de transmission optique d'un substrat saphir.
La figure 6 illustre une courbe de transmission optique d'un substrat LiNbO3.
La figure 7 illustre une courbe d'absorption optique du nitrure d'aluminium AIN.
La figure 8 illustre une courbe d'absorption optique du nitrure de titane TiN.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, les formations par épitaxie de l'au moins une couche tampon sacrificielle et de la couche d'intérêt sont configurées de sorte à ce que lesdites au moins une couche sacrificielle et couche d'intérêt soient structurellement cohérentes entre elles et avec le substrat donneur et/ou présentent entre elles et avec le substrat donneur une continuité de structure cristalline. En particulier, lesdites au moins une couche sacrificielle et couche d'intérêt et le substrat donneur présentent respectivement des structures cristallines alignées dans le plan du substrat donneur. Cela permet de conserver la qualité cristalline du substrat donneur. Le substrat donneur est de préférence monocristallin. Les épaisseurs de couches formées, notamment celle de la couche tampon sacrificielle, sont de préférence choisies de façon à éviter une relaxation plastique des contraintes. L'épaisseur de couche tampon sacrificielle peut typiquement être inférieure à une épaisseur critique au-delà de laquelle se produit la relaxation plastique. La croissance de la couche tampon sacrificielle, pour des épaisseurs inférieures à l'épaisseur critique, peut être pseudomorphe. La couche tampon sacrificielle présente dès lors sensiblement le même paramètre de maille que le substrat donneur. Dans le cas d'une couche d'intérêt de même nature que le substrat, la croissance de ladite couche d'intérêt sur la couche tampon sacrificielle s'approche dès lors d'une homoépitaxie. La cohérence structurelle correspond à l'alignement des réseaux cristallins. Cette cohérence peut être vérifiée par diffraction des rayons X.

Selon un exemple, l'élimination de la couche tampon sacrificielle par illumination permet à elle seule de désolidariser la couche d'intérêt du substrat donneur. Alternativement, pour parvenir à une désolidarisation complète de la couche d'intérêt vis-à-vis du substrat donneur, on applique également une étape additionnelle, par exemple une sollicitation mécanique contribuant au décollement de la couche d'intérêt.

Selon un exemple, la couche d'intérêt est à base d'un matériau ABO3, O étant l'oxygène, A étant au moins un premier élément chimique pris parmi le lithium (Li), le sodium (Na), le potassium (K), le baryum (Ba), le plomb (Pb), et B étant au moins un élément chimique pris parmi le plomb (Pb), le zirconium (Zr), le titane (Ti), le niobium (Nb), le tantale (Ta).

Selon un exemple, la couche d'intérêt est à base de l'un parmi le niobate de lithium LiNbO3, le tantalate de lithium LiTaO3, ou le Li(Nb, Ta)O3. Selon un exemple, la couche d'intérêt est à base d'une pérovskite oxyde ABO3 prise parmi BaTiO3, Pb(Zr,Ti)O3, (K,Na)NbO3.

Selon un exemple, la longueur d'onde λ du laser est choisie dans le domaine infrarouge. Selon un exemple, le matériau sacrificiel absorbant de l'au moins une couche tampon sacrificielle est à base d'un nitrure réfractaire de transition, par exemple TiN, VN, ZrN, TaN, HfN, NbN, ou leurs alliages. Ces matériaux présentent notamment une bonne absorption dans le domaine IR.

Selon un exemple, la longueur d'onde λ du laser est choisie dans le domaine ultraviolet. Selon un exemple, le matériau sacrificiel absorbant de l'au moins une couche tampon sacrificielle est à base d'un nitrure III-N, par exemple du nitrure d'aluminium AIN, du nitrure de gallium GaN, du nitrure de bore BN, du nitrure d'indium InN, ou leurs alliages. Ces matériaux présentent notamment une bonne absorption dans le domaine UV.

Selon un exemple, la formation de l'au moins une couche tampon sacrificielle comprend au moins une séquence comprenant :
- une formation d'une première couche tampon sacrificielle à base du matériau sacrificiel absorbant, puis
- une formation d'une couche intercalaire à base du matériau transparent du substrat, puis
- une formation d'une deuxième couche tampon sacrificielle à base du matériau absorbant.

Cela permet d'augmenter l'épaisseur totale de matériau sacrificiel absorbant, par exemple au-delà d'une épaisseur critique, en conservant des épaisseurs de matériau sacrificiel absorbant limitées, pour chacune des première et deuxième couches tampon sacrificielles. Ainsi, les épaisseurs de chacune des couches tampon sacrificielles peuvent être chacune inférieure à l'épaisseur critique, ce qui permet de conserver une bonne relation d'épitaxie, tout en offrant une épaisseur totale de matériau sacrificiel absorbant suffisante pour absorber significativement le flux lumineux de longueur d'onde λ lors de l'illumination.

Selon un exemple, la formation de l'au moins une couche tampon sacrificielle est configurée de sorte à ce que ladite au moins une couche tampon sacrificielle présente une épaisseur inférieure à une épaisseur critique au-delà de laquelle des défauts structuraux apparaissent dans ladite au moins une couche tampon sacrificielle, lors de l'épitaxie. Une telle épaisseur critique peut être déterminée expérimentalement, en fonction notamment de la nature de ladite couche tampon sacrificielle.

Selon un exemple, le substrat et la couche d'intérêt sont à base du même matériau.

Selon un exemple, le procédé comprend en outre, avant collage de la couche d'intérêt sur le substrat receveur, une formation d'une couche dite fonctionnelle sur la couche d'intérêt. Selon un exemple, le collage de la couche d'intérêt sur le substrat receveur se fait par l'intermédiaire de ladite couche fonctionnelle.

Selon un exemple, la couche fonctionnelle forme au moins l'un parmi une électrode, un miroir réfléchissant à la longueur d'onde λ, une couche de confinement acoustique.

Selon un exemple, le matériau transparent du substrat donneur est choisi parmi les matériaux suivants : LiNbO3, LiTaO3, le saphir Al2O3. Selon un exemple, le substrat receveur est choisi à base de silicium.

Selon un exemple, le procédé comprend en outre, après désolidarisation de la couche d'intérêt du substrat donneur, un recuit de guérison.

Selon un exemple, le procédé comprend en outre, après formation de la couche d'intérêt, une planarisation de la couche d'intérêt.

Selon un exemple, le matériau sacrificiel absorbant est choisi de façon à présenter une structure cristallographique compatible avec le substrat donneur et la couche d'intérêt, telle qu'une structure hexagonale ou cubique face centrée. Cela permet de limiter l'apparition de défauts structuraux lors de la formation de la couche d'intérêt par épitaxie.

Selon un exemple, la formation de la couche tampon sacrificielle est configurée de sorte que ladite couche tampon sacrificielle présente une épaisseur e20 comprise entre 10 nm et 1000 nm, par exemple 100 nm. Cela permet d'obtenir la qualité cristalline souhaitée et/ou de limiter l'apparition de défauts structuraux.

Selon un exemple, la formation de la couche d'intérêt est configurée de sorte que ladite couche d'intérêt présente, après épitaxie, une épaisseur e30 inférieure à 100 nm, et/ou supérieure à 500 nm. Le procédé permet également de former et reporter une couche d'intérêt présentant une épaisseur e30 comprise entre 100 nm et 500 nm, comme cela pourrait être atteignable par les techniques faisant intervenir le Smart-Cut. En revanche, la formation de la couche d'intérêt selon le procédé de l'invention, permet de s'affranchir d'une implantation générant des défauts et/ou d'un recuit de guérison, qui sont des étapes nécessaires en Smart-Cut.

Selon un exemple, la formation de la couche tampon sacrificielle et/ou la formation de la couche d'intérêt sont effectuées par ablation laser puisée.

Selon un exemple, la formation de la couche tampon sacrificielle et la formation de la couche d'intérêt sont effectuées par ablation laser pulsée successivement au sein d'un même réacteur sans remise à l'air entre lesdites formations. Cela permet d'éviter une étape de nettoyage de surface intermédiaire, de réduire la durée totale du procédé et de limiter les coûts. Cela permet également d'obtenir une faible rugosité en surface de la couche d'intérêt.

Selon un exemple, la couche d'intérêt est directement au contact de la couche tampon sacrificielle. En particulier, il n'y a pas de couche d'oxyde intercalaire entre la couche tampon sacrificielle et la couche d'intérêt.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, un substrat à base de silicium s'entend par exemple d'un substrat Si, Si dopé, SiC, SiGe. Une couche à base d'AIN s'entend par exemple d'une couche AIN, AIN dopée, ou des alliages d'AIN, par exemple AlInN.

Dans la présente description, un matériau est considéré comme absorbant à une longueur d'onde λ dès lors qu'il absorbe au moins 50% d'un rayonnement lumineux de longueur d'onde λ, de préférence au moins 70% et avantageusement au moins 90%. Un matériau est considéré comme transparent à une longueur d'onde λ dès lors qu'il transmet au moins 90% d'un rayonnement lumineux de longueur d'onde λ, de préférence au moins 95%.

Plusieurs modes de réalisation de l'invention mettant en œuvre des étapes successives du procédé de transfert sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent », « intercalé » se réfèrent à des positions prises selon la direction z.

Les termes « vertical », « verticalement » se réfèrent à une direction selon z. Les termes « horizontal », « horizontalement », « latéral », « latéralement » se réfèrent à une direction dans le plan xy. Sauf mention explicite, l'épaisseur, la hauteur et la profondeur sont mesurées selon z.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

Plusieurs dispositifs électro-acoustiques de type SAW ou BAW peuvent être avantageusement fabriqués en bénéficiant du procédé de transfert décrit de la présente invention. Ces dispositifs sont par exemple :
- le SAW-TF (acronyme de « Thin Film »), qui comprend typiquement une couche mince piézoélectrique sur un substrat permettant de confiner l'onde acoustique ;
- le BAW-HBAR (acronyme de « High overtone Bulk Acoustic Resonator ») ; c'est le substrat lui-même qui est le lieu d'ondes stationnaires, typiquement sur plusieurs dizaines ou centaines de micromètres ;
- le BAW-FBAR (acronyme de « Film Bulk Acoustic Resonator ») ; c'est une membrane, séparée du substrat par une zone de vide, qui est en résonance.

Cette liste n'est pas limitative. D'autres dispositifs peuvent être envisagés.

D'autres applications sont également envisageables, par exemple dans le domaine de l'optique guidée.

Dans le cadre de la présente invention, un nitrure réfractaire de transition est un nitrure d'un métal de transition ou élément de transition (élément dont les atomes ont une sous-couche électronique *d* incomplète, ou qui peuvent former des cations dont la sous-couche électronique *d* est incomplète). Ces éléments sont regroupés au sein du bloc *d* du tableau périodique des éléments. Un nitrure réfractaire III-N est un nitrure à base d'un élément de la colonne III ou IIIB du tableau périodique.

Dans les exemples décrits ci-dessous, la couche LN/LT illustrée est à base de niobate de lithium LiNbO3. On entend par « LN/LT » en particulier « niobate de lithium LiNbO3 (LN) ou tantalate de lithium LiTaO3 (LT) ou un alliage des deux du type Li(Nb,Ta)O3. D'autres couches ou matériaux, en particulier les couches à base de ABO3 mentionnées ci-dessus, peuvent être substituées à cette couche LN/LT dans le cadre de cette invention.

Des analyses en diffraction des rayons X, par exemple en configuration 2θ, ou en rotation selon ϕ et/ou Ω (phi-scan et omega-scan), peuvent être effectuées de manière à déterminer la qualité cristalline des différentes couches piézoélectriques et/ou couches tampon sacrificielles, et leur relations d'épitaxie.

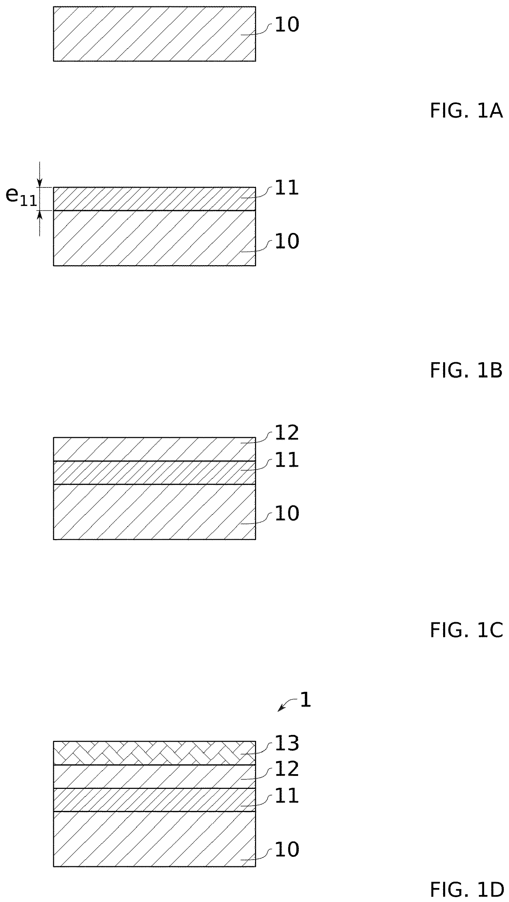

Les figures 1A à 1I illustrent en coupe transverse un procédé de transfert par lift off laser d'une couche d'intérêt selon un mode de réalisation la présente invention.

La figure 1A illustre en coupe transverse un substrat donneur 10, par exemple à base de niobate de lithium LiNbO3, de tantalate de lithium LiTaO3, ou de saphir Al2O3. Le substrat donneur 10 est de préférence monocristallin. Il peut présenter une orientation cristalline préférentielle, par exemple selon (001). D'autres orientation cristallines sont envisageables pour le substrat donneur 10, par exemple en fonction de l'application visée. Le tableau 1 ci-dessous synthétise différentes orientations cristallines possibles en fonction des applications, pour des substrats LiNbO3 et LiTaO3.

**Tableau 1**

| | Orientations préférées pour une application SAW | Orientations préférées pour une application BAW | Orientations préférées pour une application optoélectronique |
|---|---|---|---|
| LiNbO3 | (104) | (110) | (001) |
| | (110) | (012) | |
| | Y+41 cut | (202) | |
| LiTaO3 | Y+42 cut | (110) | toutes orientations |
| | | (202) | |

Le substrat donneur 10 est transparent à la longueur d'onde λ d'intérêt, c'est-à-dire à la longueur d'onde du laser utilisé pour le lift off, ultérieurement. Cela permet notamment d'illuminer la couche tampon sacrificielle 11 au travers du substrat donneur 10.

La figure 1B illustre la formation par épitaxie d'une couche tampon sacrificielle 11 en un matériau sacrificiel, par exemple à base d'AIN, ou d'AlInN, ou de GaN, ou de GalnN, sur le substrat donneur 10. Selon un autre exemple, cette couche tampon sacrificielle 11 peut être à base de nitrure de titane TiN, ou de nitrure de vanadium VN, ou de nitrure de zirconium ZrN, ou de nitrure de tantale TaN, ou de nitrure d'Hafnium HfN ou de nitrure de niobium NbN. De façon générale, le matériau sacrificiel de la couche tampon sacrificielle 11 peut être à base d'un nitrure de métal de transition, ou d'un nitrure III-N, ou d'un alliage de l'un ou l'autre de ces nitrures, par exemple TiAIN.

La couche tampon sacrificielle 11 présente une structure cristallographique compatible avec celle du substrat donneur 10, et avec celle de la couche d'intérêt pour laquelle elle sert de couche de nucléation. La couche tampon sacrificielle 11 présente par exemple une structure hexagonale ou cubique face centrée. Elle présente de préférence également une orientation cristallographique préférentielle, typiquement induite par celle du substrat donneur 10.

La couche tampon sacrificielle 11 est absorbante à la longueur d'onde λ d'intérêt. Elle absorbe typiquement au moins 20% et de préférence au moins 50 % du flux lumineux de longueur d'onde λ émis par le laser lors de l'étape de décollement par illumination. La couche tampon sacrificielle 11 est significativement plus absorbante que le substrat donneur 10 à la longueur d'onde λ d'intérêt.

Cette couche tampon sacrificielle 11 présente une épaisseur e₁₁ choisie de façon à obtenir un bon compromis entre l'absorption (plus l'épaisseur e₁₁ est grande, plus la couche 11 absorbe) et la qualité cristalline (plus l'épaisseur e11 est grande, plus la probabilité de voir apparaître des défauts structuraux au sein de la couche 11 augmente). L'épaisseur e₁₁ est de préférence inférieure à l'épaisseur critique au-delà de laquelle apparaît une relaxation plastique des contraintes. Cette épaisseur e₁₁ est typiquement comprise entre quelques nanomètres et quelques dizaines ou quelques centaines de nanomètres, par exemple entre 1 nm et 20 nm. La couche tampon sacrificielle 11 est en relation d'épitaxie avec le substrat donneur 10. Elle reste typiquement cohérente structurellement avec le substrat donneur 10, et éventuellement n'est pas relaxée (elle présente typiquement un état de contrainte résiduel). Après épitaxie, la couche tampon sacrificielle 11 présente sensiblement le même paramètre de maille que le substrat donneur 10 si elle a la même structure cristalline, ou dans le cas inverse, présente des distances interatomiques dans le plan de la croissance sensiblement proches de celles du substrat donneur 10. Elle est donc monocristalline lorsque le substrat donneur 10 est lui-même monocristallin.

La couche tampon sacrificielle 11 peut être formée par une technique de dépôt physique ou chimique, par exemple par ablation laser pulsé PLD (acronyme de « Pulsed Laser Déposition »). Elle est par exemple formée par l'une des techniques suivantes: dépôt chimique en phase vapeur (CVD, acronyme de chemical vapor déposition), préférentiellement dépôt chimique en phase vapeur à précurseurs métal-organiques (MOCVD, acronyme de metal organic chemical vapor déposition), pulvérisation cathodique PVD (sputtering).

La figure 1C illustre la formation par épitaxie d'une couche d'intérêt 12 sur la couche tampon sacrificielle 11. Cette couche d'intérêt 12 peut être par exemple à base d'un matériau dit LN/LT, à base de niobate de lithium LiNbO3 ou de tantalate de lithium LiTaO3, ou d'un alliage Li(Nb,Ta)O3. Elle est avantageusement épitaxiée sur la couche tampon sacrificielle 11 qui présente sensiblement le même paramètre de maille que le substrat donneur 10 (ou des distances interatomiques dans le plan d'interface sensiblement proches de celles du substrat donneur 10). Elle peut être monocristalline ou polycristalline, avec par exemple une orientation préférentielle. Selon une possibilité, la couche d'intérêt 12 est à base du même matériau que le substrat donneur 10. Elle peut présenter sensiblement la même qualité cristalline que le substrat donneur 10. Elle a la même orientation cristallographique. Une orientation selon un plan de croissance (001) peut être typiquement choisie. Cela permet par exemple de maximiser la vitesse de propagation des ondes acoustiques au sein d'une couche 12 LN/LT, typiquement dans le cadre d'une application aux dispositifs électroacoustiques. D'autres orientations peuvent être choisies en fonction de l'application désirée, par exemple (104), (110), (012), (202) ou selon des coupes Y+41 ou Y+42.

Cette couche d'intérêt 12 peut être formée par une technique de dépôt physique ou chimique, par exemple par ablation laser pulsée PLD. Elle est par exemple formée par l'une des techniques suivantes: dépôt chimique en phase vapeur (CVD, acronyme de chemical vapor déposition), préférentiellement dépôt chimique en phase vapeur à précurseurs métal-organiques (MOCVD, acronyme de metal organic chemical vapor déposition), pulvérisation cathodique PVD (sputtering), épitaxie par jet moléculaire (MBE, acronyme de Molecular Beam Epitaxy).

La couche d'intérêt 12 LN/LT formée sur la couche sacrificielle 11 est de préférence stœchiométrique, par exemple Li₁Nb₁O₃. Le pourcentage atomique de lithium est idéalement proche de 50 %. La couche d'intérêt 12 LN/LT présente une épaisseur e₁₂ typiquement comprise entre quelques dizaines ou centaines de nanomètres et quelques microns, par exemple de l'ordre de 200 nm. L'épaisseur e₁₂ de la couche d'intérêt 12 peut être choisie en fonction de l'application désirée, par exemple en fonction de la fréquence de résonance souhaitée pour un dispositif électro-acoustique, ou encore en fonction de la longueur d'onde d'un flux lumineux à guider pour un guide d'onde optique.

Selon une possibilité, la couche tampon sacrificielle 11 et la couche d'intérêt 12 sont toutes deux réalisées *in situ* par PLD dans un même réacteur de croissance. La croissance de la couche d'intérêt 12 peut ainsi être réalisée directement après la fin de croissance de la couche tampon sacrificielle 11. Cela permet d'éviter une remise à l'air de la couche tampon sacrificielle 11 avant épitaxie de la couche d'intérêt 12. La surface de la couche tampon sacrificielle 11 reste donc propre. Cela évite une étape de nettoyage intermédiaire. La durée du procédé est ainsi diminuée. Cela permet également de limiter l'apparition de rugosité lors de la formation de la couche d'intérêt 12. L'état de surface de cette dernière est ainsi optimisé.

A ce stade, les épitaxies successives des couches 11 et 12 permettent notamment d'obtenir une couche d'intérêt 12, par exemple en LiNbO3 stœchiométrique, orientée préférentiellement et de haute qualité cristalline. L'épaisseur e₁₂ de cette couche d'intérêt 12 obtenue par épitaxie est en outre parfaitement contrôlée.

Comme illustré à la figure 1D, après croissance de la couche d'intérêt 12, une couche de collage 13, par exemple à base de SiO2, peut être déposée sur la couche d'intérêt 12 de façon à former l'empilement 1. Cette couche de collage 13 peut être alternativement à base d'une résine, par exemple une résine époxy.

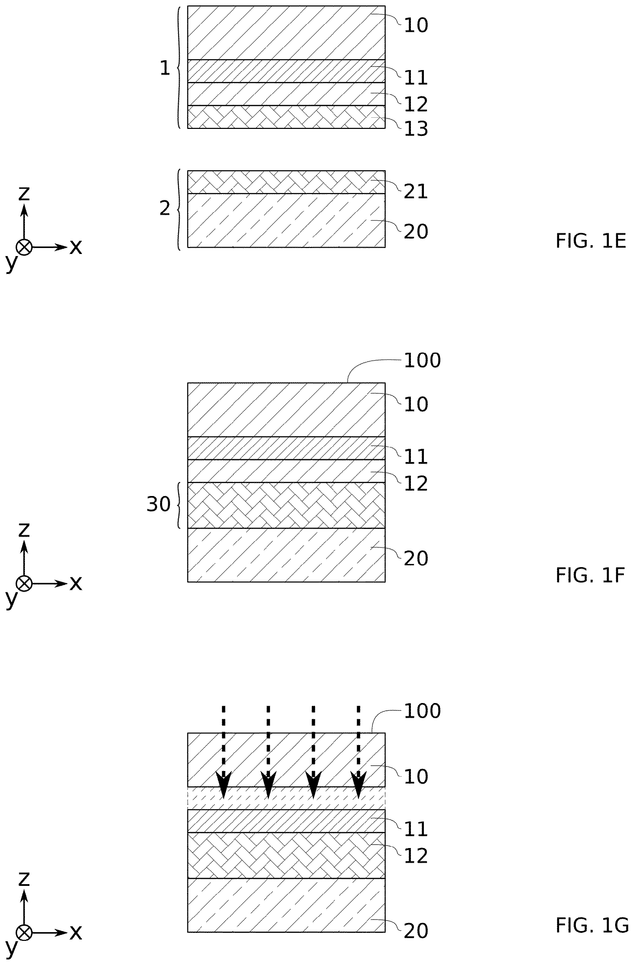

Comme illustré à la figure 1E, l'empilement 1 est alors amené en regard d'un deuxième empilement 2 comprenant le substrat receveur 20 et de préférence une deuxième couche de collage 21, par exemple à base de SiO2. Dans l'exemple illustré à la figure 1E, le collage des empilements 1 et 2 se fait par collage moléculaire entre les couches de collage 13, 21 en regard l'une de l'autre. Un tel collage moléculaire est parfaitement connu de l'homme du métier.

Le substrat receveur 20 peut être un substrat massif de silicium, dit bulk. Alternativement ce substrat 20 peut être un substrat de type SOI (acronyme de « Silicon On Insulator » signifiant silicium sur isolant). D'autres substrats receveurs 20 peuvent être envisagés, par exemple des substrats à base de SiC, des substrats à base de SiGe, des substrats GeOI (acronyme de «Germanium On Insulator » signifiant germanium sur isolant). De tels substrats présentent une compatibilité totale avec les technologies silicium pour la micro-électronique.

La figure 1F illustre les deux substrats 10, 20 collés par l'intermédiaire de la couche 30, après collage moléculaire.

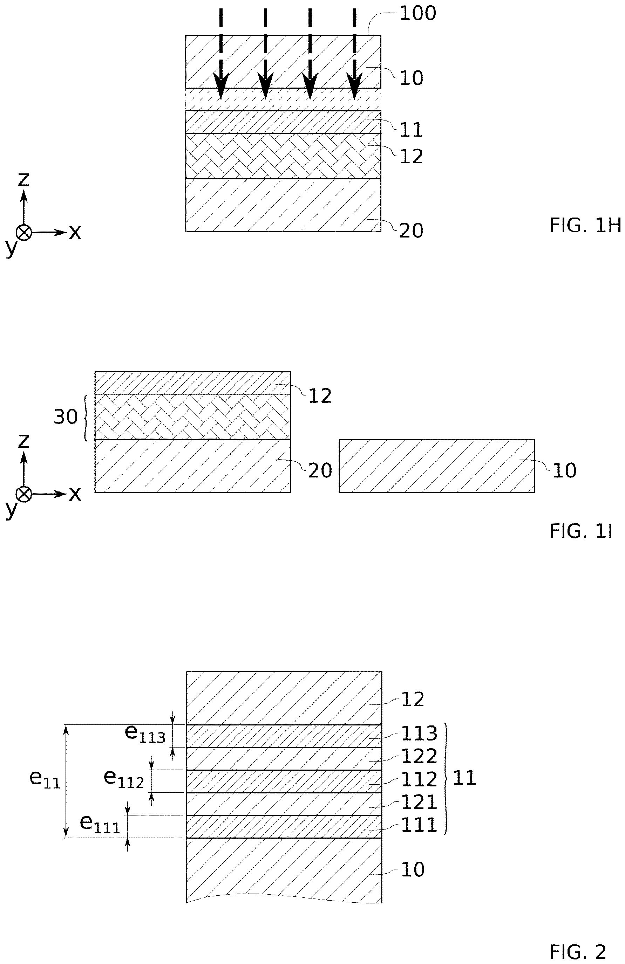

Les figures 1G et 1H illustrent des étapes d'illumination par laser de la couche tampon sacrificielle 11, respectivement aux longueurs d'onde λ = λ1 et λ = λ2. Ces étapes peuvent être effectuées en alternative l'une de l'autre. L'illumination se fait de préférence depuis une face arrière 100 du substrat donneur 10. Le substrat donneur 10 est transparent aux longueurs d'onde λ1 et λ2. La couche sacrificielle 11 est absorbante à la longueur d'onde λ1 et/ou λ2. Selon un exemple illustré à la figure 1G, la couche tampon sacrificielle 11 est à base d'un nitrure III-N et la longueur d'onde λ = λ1 est choisie dans le domaine UV, par exemple λ1 = 248 nm avec une couche 11 en GaN. Selon un exemple alternatif illustré à la figure 1H, la couche sacrificielle 11 est à base d'un nitrure de transition et la longueur d'onde λ = λ2 est choisie dans le domaine IR, par exemple λ2 = 1100 nm avec une couche 11 en TiN.

L'étape d'illumination est configurée de manière à éliminer au moins partiellement la couche tampon sacrificielle 11, de façon à décoller ou désolidariser la couche d'intérêt 12 du substrat donneur 10. Une partie 11v de la couche sacrificielle 11 peut être typiquement vaporisée ou dissociée lors de cette étape d'illumination. Les paramètres d'illumination, notamment la fluence du laser, sont choisis et adaptés en fonction de l'épaisseur et de la nature de la couche sacrificielle 11, de façon à permettre cette élimination ou dissociation partielle. La fluence du laser peut par exemple être comprise entre 200mJ/cm² et 500mJ/cm², et sera adaptée en fonction de la durée d'application du laser. Le laser peut être pulsé. Une fluence de laser de 400mJ/cm² pendant 38ns permet typiquement d'éliminer ou de dissocier une couche tampon sacrificielle à base de GaN.

Comme illustré à la figure 1I, après illumination, le substrat donneur 10 peut être séparé de la couche d'intérêt 12. La couche d'intérêt 12 se retrouve alors sur le substrat receveur 20 par l'intermédiaire de la couche de collage 30. Une étape optionnelle de planarisation, par exemple par polissage mécano-chimique CMP ou par gravure, peut être effectuée à la surface de la couche d'intérêt 12, par exemple pour éliminer complètement des résidus provenant de la couche tampon sacrificielle 11. Le substrat donneur 10 peut en outre être avantageusement réutilisé, par exemple pour de nouvelles épitaxies de couche tampon sacrificielle 11 et de couche d'intérêt 12. Cela permet de diminuer le coût du procédé.

La figure 2 illustre un autre mode de réalisation dans lequel la couche tampon sacrificielle 11 comprend des sous-couches absorbantes 111, 112, 113 et des sous-couches transparentes 121, 122 en alternance. Dans cet exemple, les sous-couches absorbantes 111, 112, 113 sont à base du matériau sacrificiel, et les sous-couches transparentes 121, 122 sont à base du matériau LN/LT. La formation d'une couche tampon sacrificielle 11 en plusieurs sous-couches 111, 112, 113 permet avantageusement d'augmenter l'épaisseur totale e₁₁ de couche absorbante, tout en évitant de dépasser l'épaisseur critique pour chacune des sous-couches 111, 112, 113. Ainsi, chaque épaisseur e₁₁₁, e₁₁₂, e₁₁₃ est inférieure à l'épaisseur critique au-delà de laquelle apparaît une relaxation des contraintes. Cela permet de limiter l'apparition de défauts dans ces sous-couches, en particulier des dislocations. Les sous-couches transparentes 121, 122 formées par épitaxie présentent dès lors une bonne qualité cristalline. Cela permet de conserver une bonne relation d'épitaxie tout le long de l'empilement des sous-couches 111, 121, 112, 122, 113. La couche d'intérêt 12 peut dès lors être formée par épitaxie avec une qualité cristalline améliorée. L'épaisseur totale e₁₁ des couches absorbantes étant par ailleurs augmentée, l'absorption du flux laser lors de l'illumination est améliorée. Cela induit une augmentation localisée de température au niveau d'une ou plusieurs sous-couches 111, 112, 113. La dissociation de la couche tampon sacrificielle 11 est facilitée.

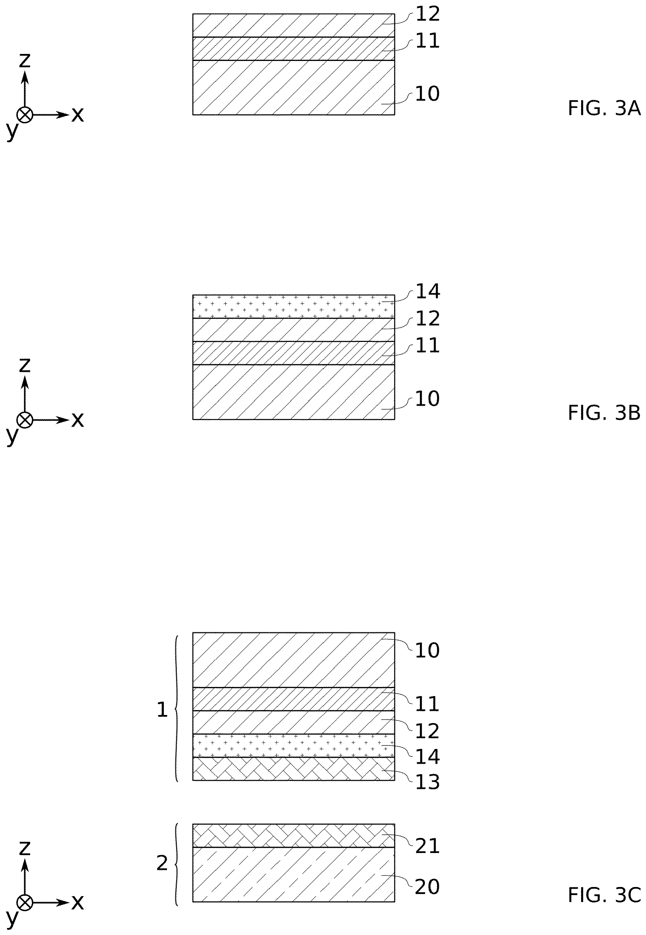

Les figures 3A à 3F illustrent en coupe transverse un procédé de transfert par lift off laser d'une couche d'intérêt selon un autre mode de réalisation la présente invention.

La figure 3A illustre en coupe transverse un empilement comprenant le substrat 10, la couche tampon sacrificielle 11 et la couche d'intérêt 12, obtenu comme précédemment et également illustré à la figure 1C.

Dans ce mode de réalisation, comme illustré à la figure 3B, une couche fonctionnelle 14, ici un miroir, est formée sur la couche d'intérêt 12. Ce miroir 14 est destiné à réfléchir au moins en partie le flux lumineux de longueur d'onde λ mis en œuvre lors du lift off laser. Le matériau utilisé pour le miroir 14 est notamment choisi en fonction de la longueur d'onde λ = λ1, λ2 choisie pour la phase d'illumination. Il peut être typiquement à base d'un métal, par exemple en aluminium. Le miroir 14 peut présenter une épaisseur de l'ordre de quelques dizaines de nanomètres à quelques centaines de nanomètres.

Comme illustré à la figure 3C, la couche de collage 13 est formée sur le miroir 14, puis ce premier empilement 1 est amené en regard du deuxième empilement 2 afin de procéder au collage moléculaire, comme précédemment.

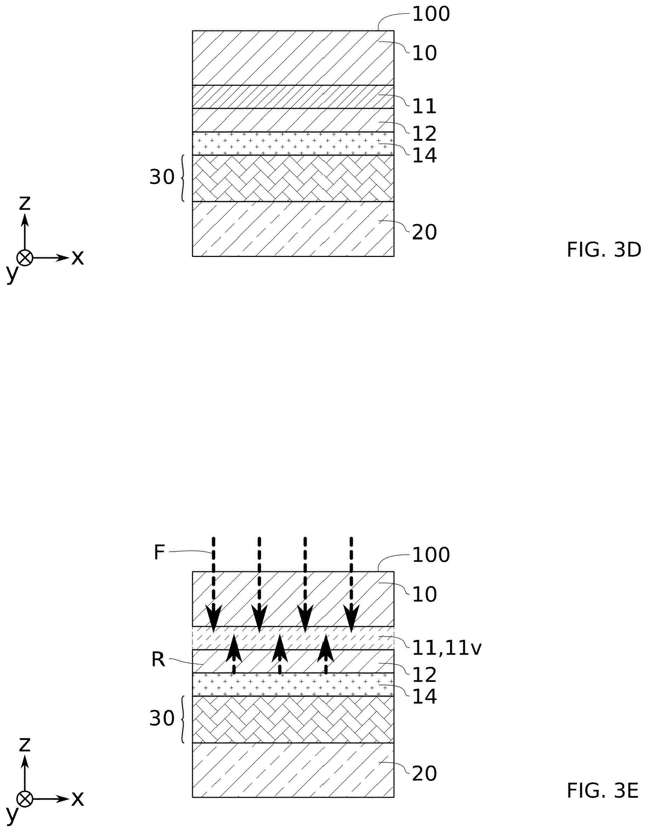

On obtient alors une structure comprenant, en empilement selon z, le substrat receveur 20, la couche de collage 30, le miroir 14, la couche d'intérêt 12, la couche tampon sacrificielle 11, et le substrat donneur 10, tel qu'illustré à la figure 3D.

Comme illustré à la figure 3E, l'illumination de la couche tampon sacrificielle 11 est ensuite effectuée au travers du substrat 10, depuis la face arrière 100. Avantageusement, le miroir 14 permet de réfléchir une partie du flux lumineux qui n'a pas été absorbé par la couche tampon sacrificielle 11, de façon à renvoyer ce flux non absorbé en direction de la couche tampon sacrificielle 11. La couche tampon sacrificielle 11 est ainsi illuminée de façon directe, par le flux lumineux principal F venant du substrat 10, et de façon indirecte, par le flux lumineux réfléchi R venant du miroir 14. Cela permet d'augmenter la quantité de flux lumineux effectivement absorbée par la couche sacrificielle 11. La puissance optique et/ou la fluence du laser peuvent être diminuées tout en permettant de dissocier une partie 11v de la couche sacrificielle 11. Cela évite ou limite un endommagement du substrat 10 et/ou de la couche d'intérêt 12 et/ou du substrat 20. Cela permet également d'utiliser une épaisseur de couche tampon sacrificielle 11 réduite, par rapport à un mode de réalisation sans miroir. Une épaisseur de couche tampon sacrificielle 11 réduite permet notamment de limiter l'apparition de défauts dans la couche d'intérêt 12.

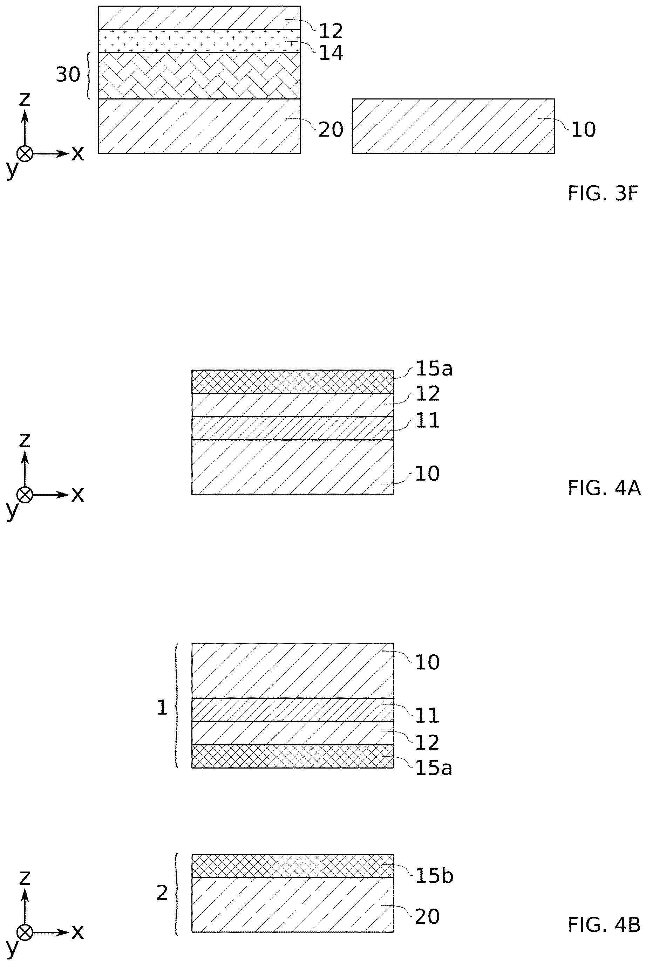

Comme illustré à la figure 3F, le substrat 10 est alors décollé, et la couche d'intérêt 12 est ainsi transférée sur le substrat receveur 20. Le miroir 14 reste intercalé entre le substrat receveur 20 et la couche d'intérêt 12. Une étape optionnelle de planarisation, par exemple par polissage mécano-chimique CMP ou par gravure, peut être effectuée à la surface de la couche d'intérêt 12, par exemple pour éliminer complètement des résidus provenant de la couche tampon sacrificielle 11.

Selon une autre possibilité illustrée aux figures 4A à 4E, la couche fonctionnelle 14 peut également servir d'électrode dans le cadre de la fabrication d'un dispositif, par exemple un dispositif électro-acoustique de type BAW.

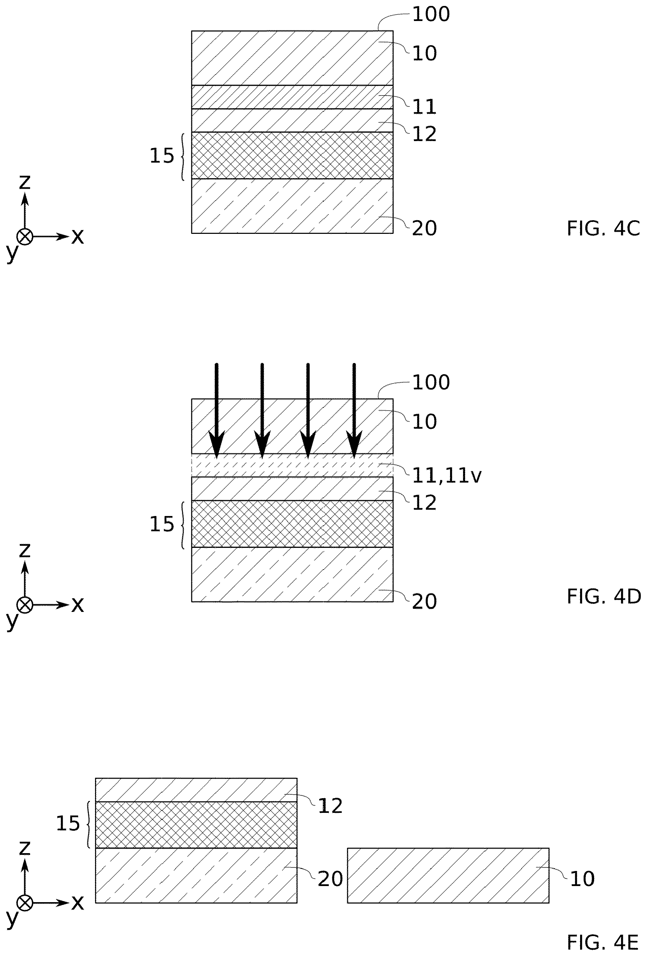

Selon un exemple, une partie 15a de l'électrode peut être formée sur la couche d'intérêt 12, comme illustré à la figure 4A. Une deuxième partie 15b d'électrode peut être formée sur le substrat receveur 20 (figure 4B). Le collage peut dès lors être effectué entre les deux parties 15a, 15b d'électrode, par exemple un collage Au-Au dans le cas de parties 15a, 15b d'électrode à base d'or Au, ou un collage AI-AI dans le cas de parties 15a, 15b d'électrode à base d'aluminium Al. Les deux parties 15a, 15b d'électrode servent ainsi avantageusement de couches de collage pour coller les deux empilements 1, 2. En outre, après collage, les deux parties 15a, 15b d'électrode forment une électrode 15 présentant une épaisseur e₁₅ adaptée à la fonction d'électrode, typiquement de plusieurs centaines de nanomètres (figure 4C).

Comme précédemment, le lift off laser est ensuite effectué (figure 4D). Selon une possibilité, l'électrode 15 forme également un miroir pour le flux lumineux de longueur d'onde λ, et permet d'augmenter l'absorption du flux lumineux dans la couche tampon sacrificielle 11.

Comme illustré à la figure 4E, le substrat 10 est alors décollé. On obtient ainsi une couche d'intérêt 12 directement sur l'électrode 15, le tout étant porté par un substrat receveur 20 typiquement choisi en fonction de l'application souhaitée pour le dispositif final. Une deuxième électrode (non illustrée) peut être formée en surface de la couche d'intérêt 12. Selon un exemple, on forme ainsi un filtre BAW sur un substrat receveur en silicium, avec une couche LN/LT d'épaisseur parfaitement contrôlée et d'excellente qualité cristalline.

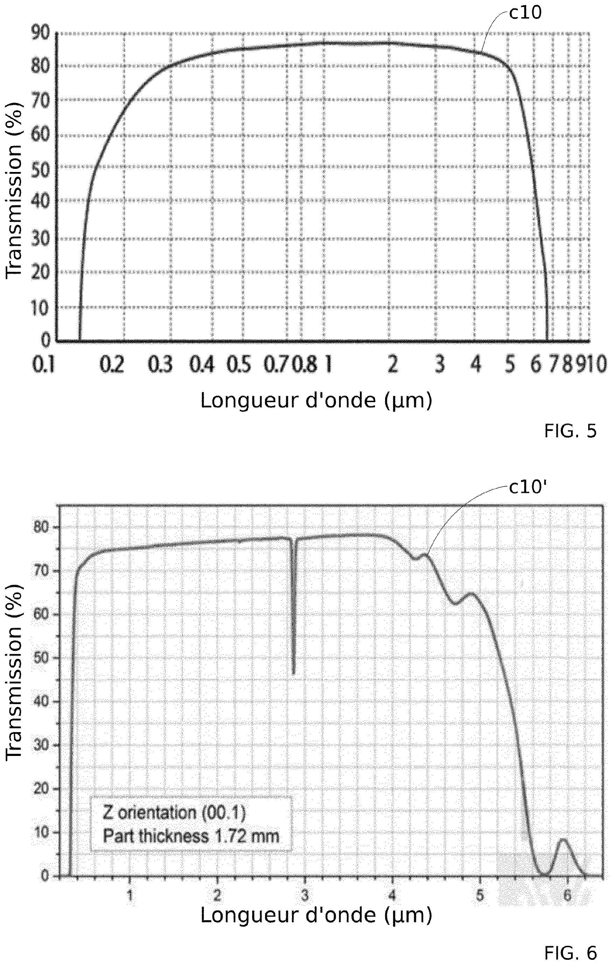

Les figures 5 et 6 illustrent des courbes de transmission c10, c10' respectivement pour du saphir Al2O3 et pour du niobate de lithium LiNbO3. Ces matériaux sont transparents dans le proche UV et dans l'IR, et conviennent parfaitement pour un substrat donneur 10 dans la mise en œuvre du procédé selon l'invention.

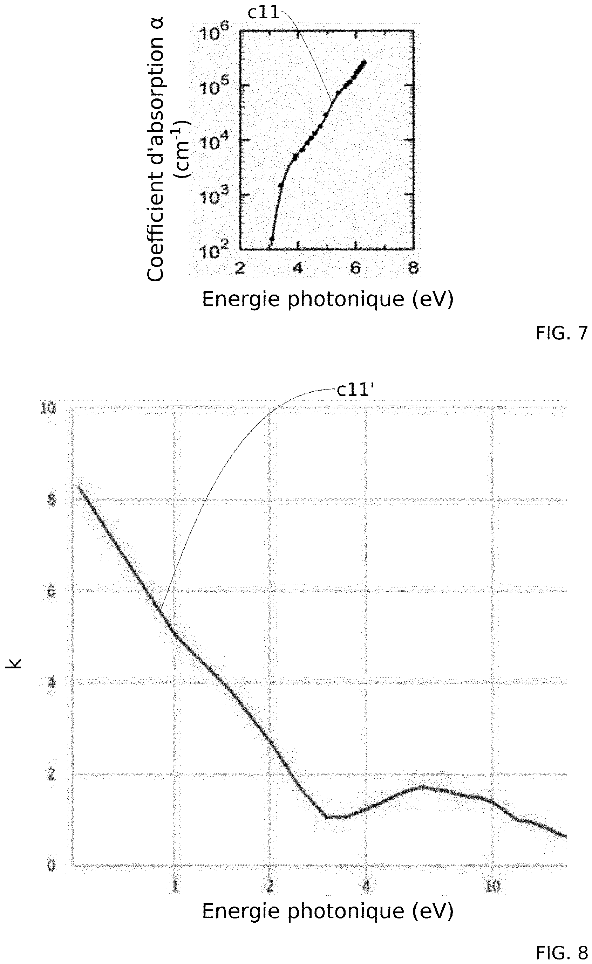

Les figures 7 et 8 illustrent des courbes d'absorption c11, c11' respectivement pour du nitrure d'aluminium AIN et pour du nitrure de titane TiN. Ces matériaux sont respectivement absorbants dans le proche UV et dans l'IR, et conviennent pour une couche tampon sacrificielle 11 dans la mise en œuvre du procédé selon l'invention. D'autres matériaux nitrures sont parfaitement envisageables, notamment des alliages, par exemple AlInN ou GalnN, de façon à ajuster les propriétés d'absorption et/ou la structure cristallographique vis-à-vis du substrat donneur 10.

L'invention n'est pas limitée aux modes de réalisation précédemment décrits.

## Revendications

1. Procédé de report d'une couche d'intérêt (12) depuis un substrat donneur (10) vers un substrat receveur (20), ladite couche d'intérêt (12) étant à base d'un matériau ABO3, O étant l'oxygène, A étant au moins un premier élément chimique pris parmi le sodium (Na), le potassium (K), le baryum (Ba), le plomb (Pb), et B étant au moins un élément chimique pris parmi le lithium (Li), le plomb (Pb), le zirconium (Zr), le titane (Ti), le niobium (Nb), le tantale (Ta), ledit procédé comprenant les étapes suivantes :
• Fournir le substrat donneur (10) en un matériau transparent à une longueur d'onde λ,
• Former au moins une couche tampon sacrificielle (11) en un matériau sacrificiel absorbant à la longueur d'onde λ, par épitaxie sur le substrat donneur,
• Former la couche d'intérêt (12) par épitaxie sur l'au moins une couche tampon sacrificielle (11),
• Coller la couche d'intérêt (12) sur le substrat receveur (20),
• Illuminer par laser à la longueur d'onde λ l'au moins une couche tampon sacrificielle (11) au travers du substrat donneur (10), de sorte à éliminer au moins en partie ladite au moins une couche tampon sacrificielle (11) pour désolidariser la couche d'intérêt (12) du substrat donneur (10).

2. Procédé selon la revendication précédente dans lequel les formations par épitaxie de l'au moins une couche tampon sacrificielle (11) et de la couche d'intérêt (12) sont configurées de sorte à ce que lesdites au moins une couche sacrificielle (11) et couche d'intérêt (12) présentent entre elles et avec le substrat donneur (10) une continuité de structure cristalline.

3. Procédé selon l'une quelconque des revendications précédentes dans lequel le matériau ABO3 est pris parmi le niobate de lithium LiNbO3, le tantalate de lithium LiTaO3, ou un alliage Li(Nb,Ta)O3.

4. Procédé selon l'une quelconque des revendications précédentes dans lequel la longueur d'onde λ du laser est choisie dans le domaine infrarouge, et dans lequel le matériau sacrificiel absorbant de l'au moins une couche tampon sacrificielle (11) est à base d'un nitrure réfractaire de transition, par exemple TiN, VN, ZrN, TaN, HfN, NbN, ou leurs alliages.

5. Procédé selon l'une quelconque des revendications 1 à 3 dans lequel la longueur d'onde λ du laser est choisie dans le domaine ultraviolet, et dans lequel le matériau sacrificiel absorbant de l'au moins une couche tampon sacrificielle (11) est à base d'un nitrure III-N, par exemple du nitrure d'aluminium AIN, du nitrure de gallium GaN, du nitrure de bore BN, du nitrure d'indium InN, ou leurs alliages.

6. Procédé selon l'une quelconque des revendications précédentes dans lequel la formation de l'au moins une couche tampon sacrificielle (11) comprend au moins une séquence comprenant :
• une formation d'une première couche tampon sacrificielle (111) à base du matériau sacrificiel absorbant, puis
• une formation d'une couche intercalaire (121) à base du matériau transparent du substrat (10), puis
• une formation d'une deuxième couche tampon sacrificielle (112) à base du matériau absorbant.

7. Procédé selon l'une quelconque des revendications précédentes dans lequel la formation de l'au moins une couche tampon sacrificielle (11) est configurée de sorte à ce que ladite au moins une couche tampon sacrificielle (11) présente une épaisseur inférieure à une épaisseur critique au-delà de laquelle des défauts structuraux apparaissent dans ladite au moins une couche tampon sacrificielle (11), lors de l'épitaxie.

8. Procédé selon l'une quelconque des revendications précédentes dans lequel le substrat donneur (10) et la couche d'intérêt (12) sont à base du même matériau.

9. Procédé selon l'une quelconque des revendications précédentes comprenant en outre, avant collage de la couche d'intérêt (12) sur le substrat receveur (20), une formation d'une couche (14) dite fonctionnelle sur la couche d'intérêt (12), et dans lequel le collage de la couche d'intérêt (12) sur le substrat receveur se fait par l'intermédiaire de ladite couche fonctionnelle (14).

10. Procédé selon la revendication précédente dans lequel la couche fonctionnelle (14) forme au moins l'un parmi une électrode, un miroir réfléchissant à la longueur d'onde λ, une couche de confinement acoustique.

11. Procédé selon l'une quelconque des revendications précédentes dans lequel le matériau transparent du substrat donneur (10) est choisi parmi le LiNbO3, LiTaO3, le saphir Al2O3.

12. Procédé selon l'une quelconque des revendications précédentes dans lequel le substrat receveur (20) est choisi à base de silicium.

13. Procédé selon l'une quelconque des revendications précédentes comprenant en outre, après désolidarisation de la couche d'intérêt (12) du substrat donneur (10), un recuit de guérison.

14. Procédé selon l'une quelconque des revendications précédentes comprenant en outre, après formation de la couche d'intérêt (12), une planarisation de la couche d'intérêt (12).
